# EUROPEAN PATENT APPLICATION

(11) **EP 3 016 398 A2**
(43) Date of publication of application: **04.05.2016**
(21) Application number: 15191329.0
(22) Date of filing: 23.10.2015
(51) Int. Cl.: H04N 21/418

(54) **SET-TOP BOX AND DISPLAY APPARATUS HAVING DISCRETE-TYPE CARD PORTION, AND CARD PORTION-MOUNTING METHODS THEREOF**

(30) Priority: 28.10.2014 KR 20140147019
(71) Applicant: Samsung Electronics Co., Ltd., Gyeonggi-do 16677 (KR)
(72) Inventor: JUNG, Byeong Woo, 17095 Gyeonggi-do (KR)
(74) Representative: Walaski, Jan Filip

(57) **Abstract**

Disclosed are a set-top box and display apparatus having a discrete-type card portion and card portion-mounting methods thereof, in which the card portion with a card such as a cable card for descrambling a scrambled signal is readily detached and attached from the outside. The set-top box includes: a signal receiver configured to receive a scrambled signal; a card portion configured to include a card slot portion to which a cable card for descrambling the received scrambled signal is mountable; a substrate configured to include the signal receiver and electrically connect with the card portion; and a housing configured to support and surround the substrate, the housing including a first opening formed on a surface parallel with the substrate, and the card slot portion of the card portion being disposed to face the substrate with the first opening of the housing therebetween.

## Description

The present invention relates to a set-top box and display apparatus having a discrete-type card portion, and more particularly to a set-top box and display apparatus having a discrete-type card portion and card portion-mounting methods thereof, in which the card portion with a personal computer memory card international association (PCMCIA) card such as a cable card for descrambling a scrambled signal is readily detached and attached from the outside and thus its maintenance is easy.

In general, a set-top box (STB) or a display apparatus such as a digital television (TV) having a set-top box function includes a card portion with a PCMCIA card such as a cable card for descrambling a scrambled broadcast signal.

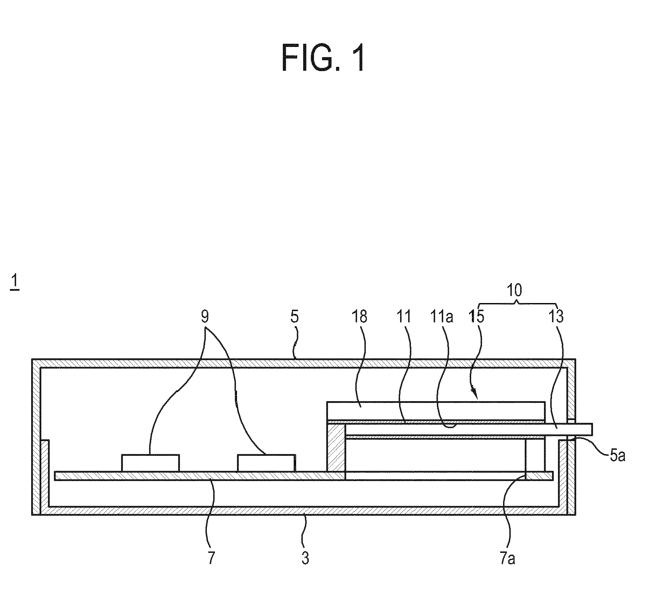

As shown in FIG. 1, a card portion 10 of a set-top box 1 generally has a card mounting portion 15 to which a card 13 such as a cable card is mounted.

The card mounting portion 15 is provided on a main substrate 7 inside the set-top box 1 so that an inlet opening 11a of a card slot 11 can be aligned with a card insertion opening 5a of an upper cover 5. When the card 13 is inserted through the inlet opening 11a of the card slot 11, a pin socket positioned at a front end portion of the card 13 is connected to pin terminals arranged inside the card slot 11. The main substrate 7 is fastened to a bottom frame 3, and the bottom frame 3 is covered with the upper cover 5.

Therefore, if the card mounting portion 15 needs to be repaired or replaced due to failure or the like, the whole upper cover 5 has to be separated from the bottom frame 3 in order to approach and detach the card mounting portion 15.

Further, the area of the main substrate 7 for mounting parts thereon is wasted as much as the area occupied by the card mounting portion 15 since the card mounting portion 15 is installed on the main substrate 7. In result, the main substrate 7 has to be enlarged as much as the area wasted by the card mounting portion 15 in order to mount the foregoing parts thereon, and thus the size of the set-top box 1 increases.

In addition, the card 13 is a part that radiates heat by itself, and therefore the main substrate 7 installed with the card mounting portion 15 may need to have a heat dissipating opening 7a for dissipating the heat from the card 13. In this case, man hour for manufacturing the main substrate 7 increases.

Further, the card 13 is likely to be affected by heat generated by a heat radiating element 9 of the set-top box 1 since the card 13 is placed inside the set-top box 1. Hence, the card mounting portion 15 may need to have an additional cooling device such as a heat sink 18 or the like with cooling pins for cooling the card 13. In this case, the product costs of the set-top box 1 increases.

Accordingly, a new card portion has been required to solve the foregoing problems of the conventional card portion 10.

An aspect of exemplary embodiments provides a set-top box and display apparatus having a discrete-type card portion and card portion-mounting methods thereof, in which the card portion with a PCMCIA card such as a cable card for descrambling a scrambled signal is readily detached and attached from the outside and thus its maintenance is easy.

Another aspect of exemplary embodiments provides a set-top box and display apparatus having a discrete-type card portion and card portion-mounting methods thereof, in which an installation structure for the card portion is improved to increase a usable area of a main substrate and thus decrease the sizes of the substrate and apparatus.

Still another aspect of exemplary embodiments provides a set-top box and display apparatus having a discrete-type card portion and card portion-mounting methods thereof, in which a cooling structure of the card portion is improved to not only raise a cooling efficiency of the card portion but also reduce product costs.

In accordance with an exemplary embodiment, there is provided a set-top box including: a signal receiver configured to receive a scrambled signal; a card portion configured to include a card slot portion to which a cable card for descrambling the received scrambled signal is mounted; a substrate configured to include the signal receiver and electrically connect with the card portion; and a housing configured to support and surround the substrate, the housing including a first opening formed on a surface parallel with the substrate, and the card slot portion of the card portion being disposed to face the substrate with the first opening of the housing therebetween.

In this set-top box, the card portion is exposed to the outside through the first opening, and it is thus easy to approach and detachably mount the card portion from the outside. In result, the maintenance of the card portion becomes easy.

The card portion may be installed on a first surface of the substrate. Thus, the card portion may be installed on the first surface where the circuit parts are not mounted. In result, the usable area of the substrate increases, and thus the sizes of the substrate and device decreases.

Alternatively, the card portion may be installed on a second surface of the substrate. Thus, the card portion may be also installed on the second surface of the substrate where the circuit parts are mounted in accordance with design.

The card portion may include a connection socket mounted with the cable card and electrically connecting with the substrate, the connection socket including: a first socket portion configured to penetrate the first opening and electrically connect with the substrate; a second socket portion configured to includes a first surface electrically connecting with the first socket portion and a second surface electrically connecting with the cable card; and the card slot portion configured to accommodate and support the second socket portion and guide movement of the cable card parallel with the first opening so that the cable card can connect with the second surface of the second socket portion. Thus, it is easy to detach and attach the card portion from the outside.

The first opening may have a size corresponding to the card slot portion. At this time, the first socket portion may protrude outward by a predetermined distance or more from the housing through the first opening of the housing. Thus, there is provided an air flowing space via which air can flow by convection from between the housing and the card slot portion in at least one directions, for example, a direction of both sides and an inlet direction of the card slot portion through the first opening in the state that the cable card is connected to the second socket portion through the card slot portion. In result, the cooling efficiency of the card portion is improved, and there is no need of adding another cooling device, thereby reducing production costs.

The connection socket may further include a fastener configured to detachably fasten the card slot portion to one of the substrate and the housing. The fastener may include: a first fastener disposed at a first end portion of the card slot portion; and a second fastener disposed at a second end portion of the card slot portion. Thus, the connection socket can be detachably fastened to the substrate or the housing.

The first fastener may include at least one first pillar disposed at each first end portion of the card slot portion and fastened to the substrate by a screw, and the second fastener may include at least one second pillar disposed at each second end portion of the card slot portion and including a locking projection locked to the substrate.

Alternatively, the first fastener may include at least one first pillar disposed at each first end portion of the card slot portion and locked to the substrate, and the second fastener may include at least one second pillar disposed at each second end portion of the card slot portion and including a locking projection locked to the substrate.

Further, the first fastener may include at least one first fastening bracket disposed at each first end portion of the card slot portion and fixed to the housing, and the second fastener may include at least one second fastening bracket disposed at each second end portion of the card slot portion and fixed to the housing.

The housing may further include a plurality of second openings for circulating air in the set-top box outward. Thus, heat caused by the cable card and heat caused by circuit parts of the set-top box can be radiated outward.

The set-top box may further include a blowing fan for circulating air in the set-top box. Thus, heat caused by the cable card and heat caused by circuit parts of the set-top box can be more efficiently radiated outward.

The housing may include a ground disposed to contact and ground the cable card when the cable card is mounted to the connection socket. The ground includes a contact projection formed on a surface of the housing facing the cable card mounted to the card slot portion of the connection socket. Thus, it is sufficient to reinforce the ground of the card portion.

The set-top box may further include a sealing cover configured to seal up the connection socket. Thus, it is possible to restrict an approach to the card portion except permission of a content provider. The sealing cover may include a plurality of third openings formed at a position corresponding to the air flowing space where air flow by convection through the first opening. Thus, regardless of installation of the sealing cover, heat generated in the cable card is cooled by air flowing through the third opening and the air flowing space.

In accordance with another exemplary embodiment, there is provided a method of mounting the card portion of the foregoing display apparatus, which includes a housing supporting and surrounding the substrate, the method including: preparing the housing having a first opening; detachably mounting the card portion to one of the substrate and the housing; and installing the substrate in the housing so that the card slot portion of the card portion can be exposed to an outside through the first opening.

In this card portion-mounting method for the set-top box, it is easy to approach and detachably mount the card portion from the outside since the card portion is exposed through the first opening.

In accordance with still another exemplary embodiment, there is provided a display apparatus including: a signal receiver configured to receive a scrambled signal; a card portion configured to include a card slot portion to which a cable card for descrambling the scrambled signal is mounted; a video processor configured to process the descrambled signal to be displayed as an image; a display configured to display a signal processed by the video processor; a substrate configured to include the signal receiver and electrically connect with the card portion; and a housing configured to support and surround the substrate, the housing including a first opening formed on a surface parallel with the substrate, and the card slot portion of the card portion being disposed to face the substrate with the first opening of the housing therebetween.

In this display apparatus, the card portion is exposed through the first opening, and it is thus easy to approach and detachably mount the card portion from the outside.

The card portion may be installed on one side of the substrate where circuit parts are mounted.

The card portion may include a connection socket mounted with the cable card and electrically connecting with the substrate, the connection socket including: a first socket portion configured to penetrate the first opening and electrically connect with the substrate; a second socket portion configured to include a first surface electrically connecting with the first socket portion and a second surface electrically connecting with the cable card; and the card slot portion configured to accommodate and support the second socket portion and guide movement of the cable card parallel with the first opening so that the cable card can connect with the second surface of the second socket portion. Thus, the card portion can be easily attached and detached from the outside.

The first opening may have a size corresponding to at least a part of the card slot portion. At this time, the first socket portion may protrude outward by a predetermined distance or more from the housing through the first opening of the housing. Thus, there is provided an air flowing space via which air can flow by convection from between the housing and the card slot portion in at least one directions, for example, a direction of both sides and an inlet direction of the card slot portion through the first opening in the state that the cable card is connected to the second socket portion through the card slot portion. In result, the cooling efficiency of the card portion is improved, and there is no need of adding another cooling device.

The connection socket may further include a fastener configured to detachably fasten the card slot portion to one of the substrate and the housing. The fastener may include: a first fastener disposed at a first end portion of the card slot portion; and a second fastener disposed at a second end portion of the card slot portion. Thus, the connection socket is detachably fastened to the substrate or the housing.

In accordance with still another exemplary embodiment, there is provided a method of mounting the card portion of the foregoing display apparatus, which includes a housing supporting and surrounding the substrate, the method including: preparing the housing having a first opening; detachably mounting the card portion to one of the substrate and the housing; and installing the substrate in the housing so that the card slot portion of the card portion can be exposed to an outside through the first opening.

In this card portion-mounting method for the display apparatus, it is easy to approach and detachably mount the card portion from the outside since the card portion is exposed through the first opening.

The above and/or other aspects will become apparent and more readily appreciated from the following description of exemplary embodiments, taken in conjunction with the accompanying drawings, in which:
FIG. 1 is a cross-section view illustrating a set-top box having a general card portion;
FIG. 2 is an exploded perspective view illustrating a set-top box with a discrete-type card portion according to an exemplary embodiment;
FIG. 3 is a cross-section view taken along line III of FIG. 2;
FIG. 4 is a block diagram of a set-top box with a discrete-type card portion according to an exemplary embodiment;
FIG. 5 is a partial perspective view illustrating an air flowing space, in which air can flow by convection through an exposure opening in a state that a cable card is connected to a second socket portion through a card slot portion;
FIG. 6 is a view showing the card slot portion where the second socket is accommodated, along a direction of VI-VI of FIG. 3;
FIG. 7 is a view showing the card slot portion where the second socket is accommodated, along a direction of VII-VII of FIG. 3;
FIG. 8 is a view showing the card slot portion where the second socket is accommodated, along a direction of VIII-VIII of FIG. 6;
FIG. 9 is a perspective view showing an alternative example to a fastener of a card mounting portion;
FIG. 10 is a cross-section view showing another alternative example to a fastener of a card mounting portion;
FIG. 11 is a cross-section view of a set-top box with a discrete-type card portion according to another exemplary embodiment, which includes a sealing member;
FIG. 12 is a perspective view of the sealing member of FIG. 11;
FIG. 13 is a cross-section view of a set-top box with a discrete-type card portion according to still another exemplary embodiment, which includes a blowing fan for circulating air;
FIG. 14 is a cross-section view of a set-top box with a discrete-type card portion according to yet another exemplary embodiment;
FIG. 15 is a flowchart showing a card portion mounting process in the set-top box according to an exemplary embodiment;
FIG. 16 is a block diagram of a display apparatus with a discrete-type card portion according to another exemplary embodiment;
FIG. 17 is a cross-section view of a display apparatus with a discrete-type card portion according to still another exemplary embodiment; and
FIG. 18 is a flowchart showing a card portion mounting process in the display apparatus with according to yet another exemplary embodiment.

Below, a set-top box and display apparatus having a discrete-type card portion, and card portion-mounting methods thereof according to exemplary embodiments will be described in detail with reference to accompanying drawings.

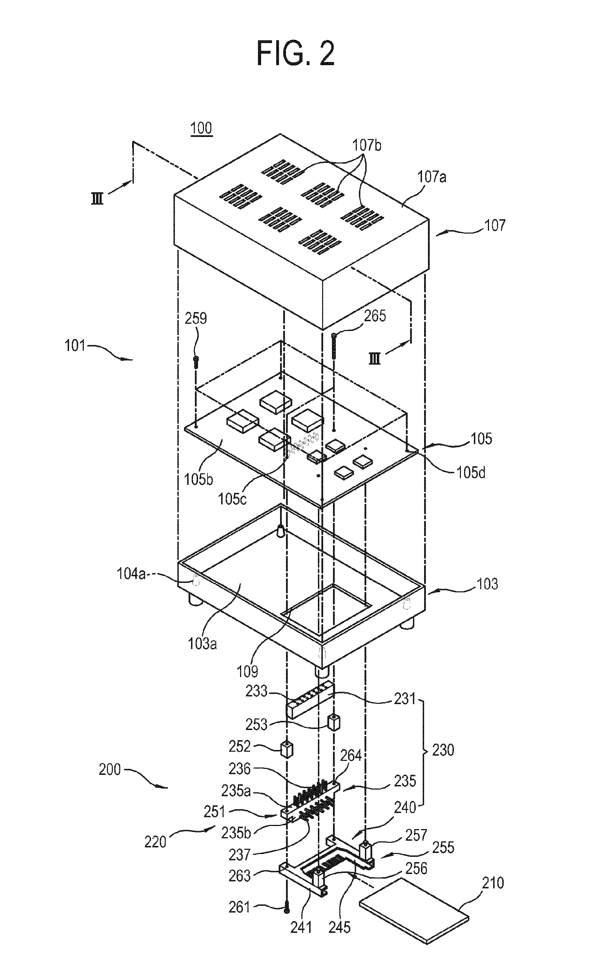

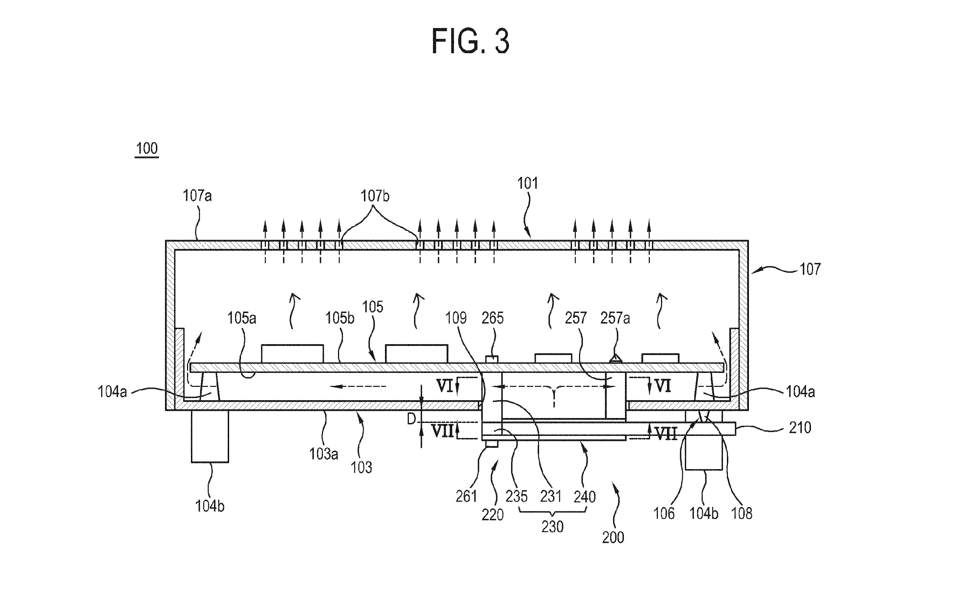

FIG. 2 and FIG. 3 are an exploded perspective view and a cross-section view of a set-top box with a discrete-type card portion according to an exemplary embodiment.

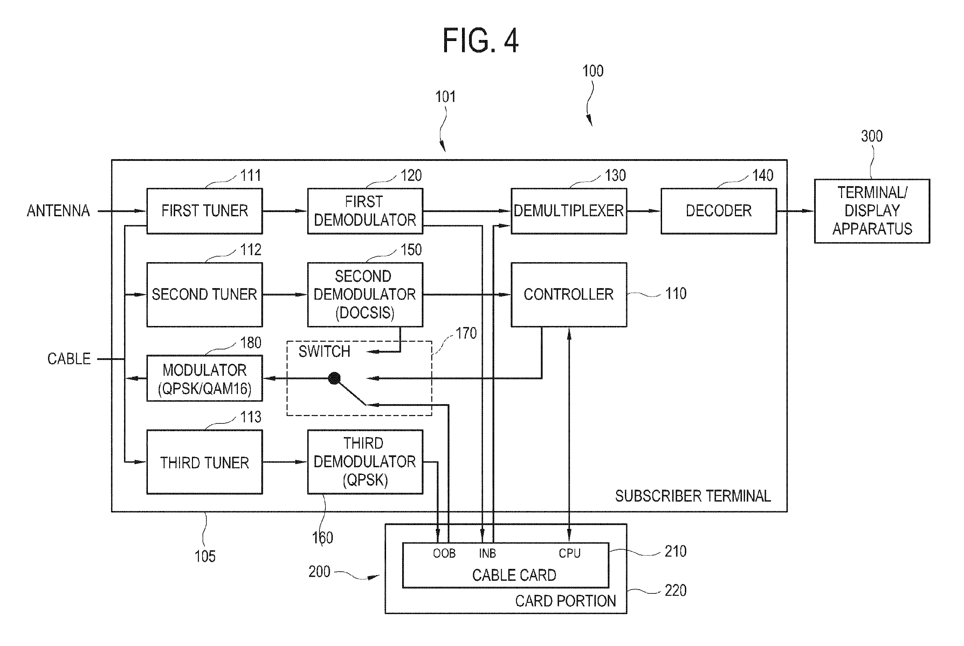

According to this exemplary embodiment, a set-top box 100 is an open cable set-top box, which receives a broadcast signal and broadcast-related information by a wire and wirelessly and transmits the received broadcast signal and broadcast-related information to the display apparatus 300 (see FIG. 4).

As shown in FIG. 2 and FIG. 3, the set-top box 100 includes a subscriber terminal (Host) 101, and a card portion 200 with a cable card 210.

The subscriber terminal 101 includes a bottom frame 103, a main substrate 105 and an upper cover 107.

The bottom frame 103 and the upper cover 107 form a housing that supports and surrounds the main substrate 105.

The bottom frame 103 is a member for supporting the main substrate 105, and is made of a metallic material and shaped like a top-opened box. On an inner surface of the bottom 103a of the bottom frame 103, first to fourth fixing lugs 104a protrude to support the main substrate 105. The first to fourth fixing lugs 104a may be positioned corresponding to four corners of the main substrate 105, respectively. Further, on an outer surface of the bottom 103a of the bottom frame 103, first to fourth support legs 104b are provided to support the set-top box 100 on a floor.

Further, the bottom frame 103 is formed with the exposure opening 109 on the bottom 103a thereof corresponding to a card mounting portion 220 of the card portion 200 to be mounted to a bottom 105a of the main substrate 105, so that the connection socket 230 of the card mounting portion 220 can be installed and at least a part of the card mounting portion 220 is exposed to the outside. The exposure opening 109 may have a size corresponding to at least a part of a card slot portion 240 of the connection socket 230. Thus, the exposure opening 109 allows the first and second socket portions 231 and 235 of the connection socket 230 and the card slot portion 240 to pass therethrough and be exposed to the outside when the card mounting portion 220 is mounted to the bottom 105a of the main substrate 105.

Further, the bottom frame 103 is provided with a ground 106 on the outer surface of the bottom 103a thereof to ground the cable card 210. The ground 106 is arranged to contact a top surface of the cable card 210 when the cable card 210 is mounted to the connection socket 230 of the card mounting portion 220. To this end, the ground 106 may include a plurality of ground projections 108 (one of them is representatively shown in FIG. 3) which protrude at regular intervals corresponding to a card mounting position on the outer surface of the bottom 103a of the bottom frame 103.

The upper cover 107 is a member for sealing up the main substrate 105 supported by the bottom frame 103, and is made of a metallic or plastic material and shaped like a bottom-opened box. The upper cover 107 receives and seals four lateral walls of the bottom frame 103, and is fastened to the bottom frame 103 by a screw or the like (not shown).

Further, the upper cover 107 is formed with a plurality of first ventilation openings 107b on a top surface 107a thereof to ventilate the inside of the subscriber terminal 101. The first ventilation openings 107b may be provided in the form of slits.

The main substrate 105 is installed in the bottom frame 103, and its bottom is supported at four corners by the first to fourth fixing lugs 104a and fastened to the first to fourth fixing lugs 104a by first fastening screws 259. Thus, the main substrate 105 is disposed at a first distance from the inner surface of the bottom 103a of the bottom frame 103.

The main substrate 105 may be achieved by a printed circuit board (PCB).

As shown in FIG. 4, circuit parts, which constitute a controller 110, first to third tuners 111, 112 and 113, first to third demodulators 120, 150 and 160, a demultiplexer 130, a decoder 140, a switch 170 and a modulator 180, are mounted to a top surface 105b of the main substrate 105.

The first to third tuners 111, 112 and 113 constitute a signal receiver for receiving a broadcast signal through an antenna and a cable.

The first tuner 111 is tuned to only a frequency corresponding to a certain channel with regard to terrestrial audio/video (A/V) broadcast signals received through the antenna or cable A/V broadcast signals received by an in-band mode through the cable and outputs the broadcast signal of the tuned channel to a first demodulator 120.

At this time, the terrestrial broadcast and the cable broadcast are different in a transmission method, and therefore differently demodulated in the first demodulator 120. That is, the terrestrial A/V broadcast signal is demodulated by vestigial sideband modulation (VSB), and the cable A/V broadcast signal is demodulated by quadrature amplitude modulation (QAM). Hence, if a channel frequency to which the first tuner 111 is tuned corresponds to the terrestrial broadcast signal, the broadcast signal is demodulated in the first demodulator 120 by the VSB. If the channel frequency corresponds to the cable broadcast signal, it is demodulated by the QAM.

Further, if a signal demodulated in the first demodulator 120 is the terrestrial broadcast signal, the demodulated signal is output to the demultiplexer 130. If a signal demodulated in the first demodulator 120 is the cable broadcast signal, the demodulated signal is output to the demultiplexer 130 via the cable card 210 mounted to the card mounting portion 220 of the card portion 200.

The demultiplexer 130 separates the multiplexed broadcast signal into a video signal and an audio signal and outputs the video signal and the audio signal to the decoder 140. The decoder 140 respectively restores compressed A/V signals into original signals through video and audio decoding algorithms, and outputs the restored signals to the display apparatus 300. At this time, the decoder 140 may download and use the video decoding algorithm and the audio decoding algorithm from a codec server (not shown) through a cable modem (not shown).

The second tuner 112 is tuned to a frequency corresponding to a certain channel with regard to data broadcast signals received by a DOCSIS set-top gateway (DSG) mode through a cable and outputs the data broadcast signal of the tuned channel to a second demodulator 150. The second demodulator 150 demodulates the DSG data broadcast signal and outputs it to the controller 110.

Further, the third tuner 113 is tuned to a frequency corresponding to a certain channel with regard to data broadcast signals received by an out of band (OOB) mode through the cable and outputs the broadcast signal of the tuned channel to a third demodulator 160. The third demodulator 160 demodulates the OBB data broadcast signal by quadrature phase shift keying (QPSK) and outputs the data broadcast signal of the tuned channel to the cable card 210 of the card portion 200. At this time, the reason why the third demodulator 160 demodulates the OOB data broadcast signal by QPSK is because the OOB mode employs the transmission method of QPSK.

Further, if interactive communication is possible between a cable broadcasting station (not shown) and the subscriber terminal 101, information (for example, pay program application, status information of the subscriber terminal 101, a user's input, etc.) to be transmitted from the subscriber terminal 101 to the cable broadcasting station is transmitted by the OOB or DSG mode. To this end, the switch 170 is provided. Switching control for the switch 170 is fulfilled in the controller 110. The controller 110 may be achieved by a central processing unit (CPU).

For instance, in the OOB mode, status information of a user or subscriber terminal 101 is output to the modulator 180 via the cable card 210 and the switch 170, demodulated in the modulator 180 by the QPSK mode, and transmitted to the cable broadcasting station via the cable. Further, in the DSG mode, status information of a user or subscriber terminal 101 is output to the modulator 180 via the controller 110 and the switch 170, modulated in the modulator 180 by a 16-QAM mode, and transmitted to the cable broadcasting station via the cable.

The card portion 200 is a discrete type card portion, and includes a card mounting portion 220 to which the cable card 210 is mounted.

The cable card 210 is to descramble a scrambled broadcast signal, and is also called a point of deployment (POD) module. The cable card 210 includes a conditional access (CA) system for copy protection with regard to a high value-added broadcast content and for restricted access.

Specifically, if the scrambled cable A/V broadcast signal is received, the cable card 210 descrambles the received broadcast signal and outputs it to the demultiplexer 130. If the cable card 210 is not mounted to the card mounting portion 220, the cable A/V broadcast signal demodulated by the first demodulator 120 is directly output to the demultiplexer 130. In this case, the scrambled cable A/V broadcast signal since is not descrambled and thus a user cannot normally view the broadcast signal.

The cable card 210 may be achieved by a single-stream card for processing only one stream or by a multi-stream card for simultaneously processing a plurality of streams.

Referring back to FIG. 2 and FIG. 3, the card mounting portion 220 is mounted with the cable card 210 and includes the connection socket 230 electrically connected to the main substrate 105.

The connection socket 230 is installed in the bottom 105a of the main substrate 105 and exposed to the outside though the exposure opening 109 of the bottom frame 103.

The connection socket 230 includes the first and second socket portions 231 and 235, and the card slot portion 240.

The first socket portion 231 has a box shape, and is arranged to electrically connect with the bottom 105a of the main substrate 105. To this end, the first socket portion 231 includes a plurality of, e.g., sixty eight first pin receiving holes 233 to connect with sixty eight substrate pin terminals substrate pin terminals 105c formed in the bottom 105a of the main substrate 105. The first pin receiving holes 233 may be formed to penetrate the first socket portion 231.

The first socket portion 231 may be formed to have a height to be extended through the exposure opening 109 of the bottom frame 103 and exposed to the outside by a predetermined distance D or more from the bottom 103a of the bottom frame 103.

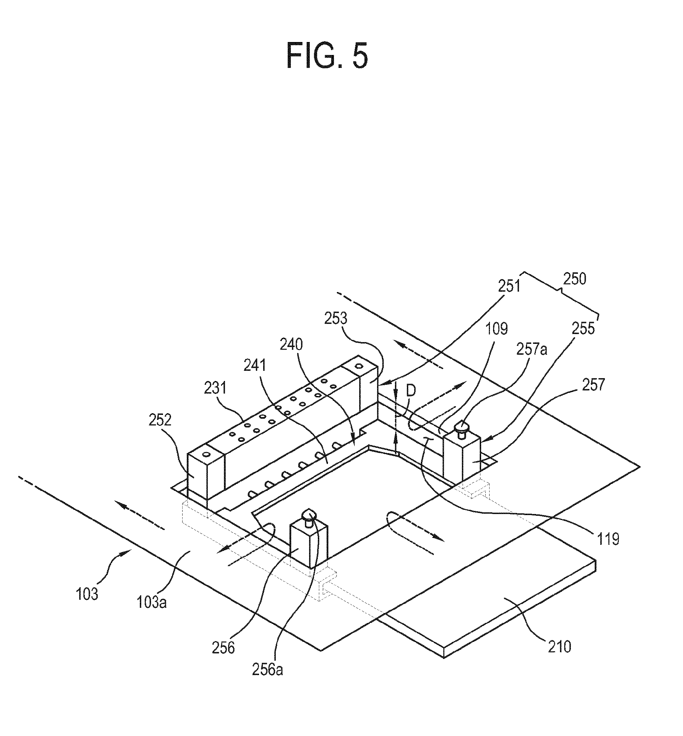

This is to provide an air flowing space 119 via which air can flow in arrow directions by convection from between the bottom 103a of the bottom frame 103 and an upper side of the card slot portion 240 toward a direction of both sides (i.e. frontward and backward directions in the drawings) and an inlet direction of the card slot portion 240 through the exposure opening 109 of the bottom frame 103 in the state that the cable card 210 is connected to the second socket portion 235 through the card slot portion 240 as shown in FIG. 3 and FIG. 5. Thus, it is possible to more efficiently dissipate heat radiated from the cable card 210.

The second socket portion 235 is shaped like a stick, and includes first and second sixty eight pin terminals 236, 237 respectively protruding from a top surface 235a and a lateral side 235b perpendicular to the top surface 235a. The first pin terminals 236 are inserted in and electrically connected to the first pin receiving holes 233 of the first socket portion 231, and the second pin terminals 237 are inserted in and electrically connected to sixty eight second pin receiving holes (not shown) formed on the front end surface of the cable card 210.

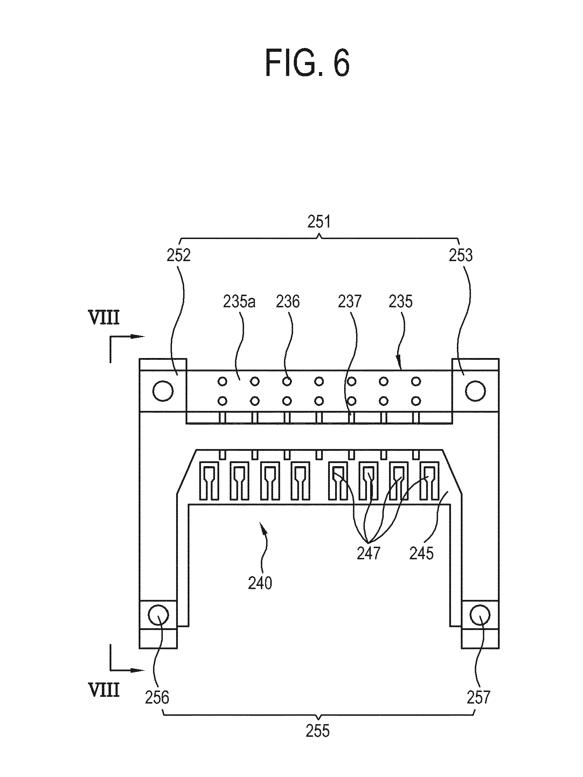

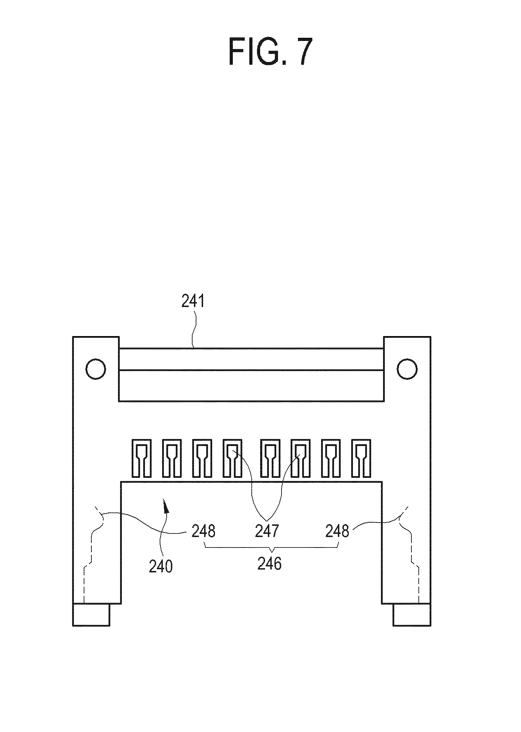

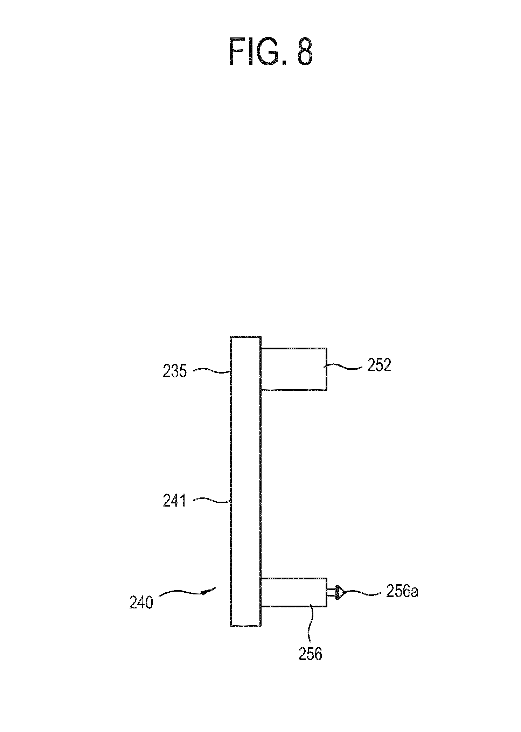

As shown in FIG. 2 and FIG. 6 to FIG. 8, the card slot portion 240 is formed with a guide frame 241 having a 'U' shape. The guide frame 241 accommodates and supports the second socket portion 235 in a mounting space inside a left end portion of the guide frame 241 ('left' refers to in relation to the drawings). The second fastening screws 261 are fixed to the first pillars 252 and 253 of the first fastener 251 (to be described later) via first screen holes 263 formed at opposite end portions of the guide frame 241 and the second screw holes 264 formed at opposite end portions of the second socket portion 235. In result, the guide frame 241, the second socket portion 235 and the first pillars 252 and 253 are coupled one another.

On the right side of the left end portion of the guide frame 241 in which the second socket portion 235 is accommodated and supported, a card insertion slot 245 is formed to guide the insertion of the cable card 210. The second socket portion 235 is installed so that the first pin terminals 236 of the top surface 235a can protrude upward from the left end portion of the guide frame 241 and the second pin terminals 237 of the lateral surface 235b can protrude toward the inside of the card insertion slot 245.

Therefore, the second socket portion 235 is not only electrically connected to but also coupled to the first socket portion 231 as the first pin terminals 236 of the top surface 235a are inserted in the first pin receiving holes 233 of the first socket portion 231. Further, when the cable card 210 is inserted in the card insertion slot 245, the second socket portion 235 electrically connects with the cable card 210 as the second pin terminals 237 of the lateral surface 235b are inserted in the second pin receiving holes of the cable card 210.

The card insertion slot 245 is provided with an elastic supporter 246 for supporting and preventing the cable card 210 from being easily separated from the card insertion slot 245 after the cable card 210 is inserted in the card insertion slot 245. The elastic supporter 246 includes a plurality of the elastic support projections 247 and first and second lateral support springs 248. The plurality of the elastic support projections 247 are aligned in a line with the bottom of the slot 245, and the first and second lateral support springs 248 are respectively formed inside the right end portions of the card insertion slot 245. Thus, when the cable card 210 is inserted in the card insertion slot 245, both lateral surfaces and the bottom of the cable card 210 are elastically supported by the elastic supporter 246, and the cable card 210 is not easily separated from the slot 245.

To detachably mount the guide frame 241 of the card slot portion 240, in which the second socket portion 235 connecting with the first socket portion 231 is accommodated and supported, to the main substrate 105, the connection socket 230 further includes a fastener 250.

As shown in FIG. 2 and FIG. 5, the fastener 250 includes a first fastener 251 and a second fastener 255.

The first fasteners 251 are respectively disposed on the opposite end portions of the second socket portion 235 and include a pair of first pillars 252 and 253 fastened to the opposite end portions of the second socket portion 235 by the second fastening screws 261. The pair of first pillars 252 and 253 is fastened to the bottom 105a of the main substrate 105 by a third fastening screw 265. The third fastening screw 265 is fastened to the first pillars 252 and 253 via through holes 105c of the main substrate 105. Thus, the left end portion of the card mounting portion 220, i.e. the left end portion of the guide frame 241, in which the second socket portion 235 connecting with the first socket portion 231 is accommodated and supported, is detachably mounted to the main substrate 105.

The second fastener 255 includes a pair of second pillars 256 and 257 respectively disposed at the right end portions of the guide frame 241. The second pillars 256 and 257 include locking projections 256a and 257a to be locked to locking grooves 105d of the main substrate 105, respectively. Thus, the right end portion of the card mounting portion 220, i.e. the right end portion of the guide frame 241 is detachably mounted to the main substrate 105.

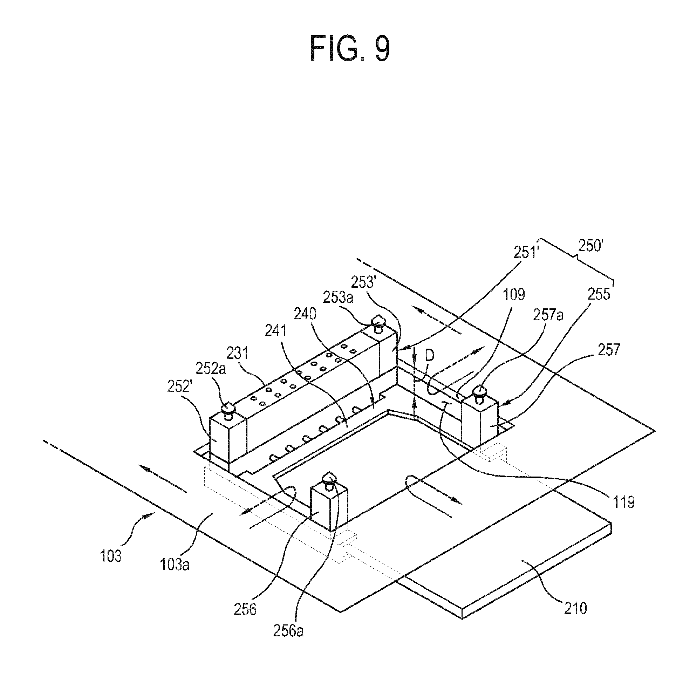

Alternatively, as shown in FIG. 9, like the second fastener 255, a first fastener 251' of a fastener 250' may include a pair of first pillars 252' and 253' having locking projections 252a and 253a to be locked to the locking grooves (not shown) of the main substrate 105.

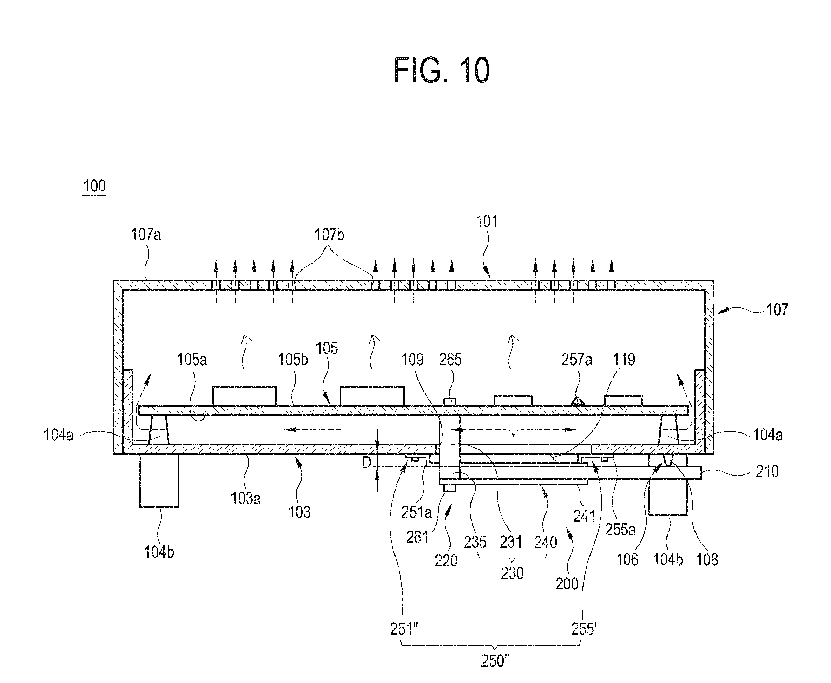

Further, as shown in FIG. 10, to detachably mount the guide frame 241 of the card slot portion 240 to the bottom frame 103, a fastener 250" may include a first fastener 251" having a pair of first fastening brackets 251a respectively protruding from both sides of the left end portion of the guide frame 241, and a second fastener 255' having a pair of second fastening brackets 255a respectively protruding from both sides of the right end portion of the guide frame 241. The first and second fastening brackets 251a and 255a may be fastened to the bottom 103a of the bottom frame 103 by screws.

Thus, when the first socket portion 231, the second socket portion 235, the card slot portion 240 or the like needs to be repaired or replaced due to damage in the first and second pin terminals 236 and 237 of the second socket portion 235, a connection defect between the first socket portion 231 and the pin receiving holes of the cable card 210, etc., the connection socket 230 can be repaired and replaced by easily separating the first socket portion 231, the second socket portion 235, the card slot portion 240 or the like from the bottom 103a of the bottom frame 103 through the fastener 250 from the outside.

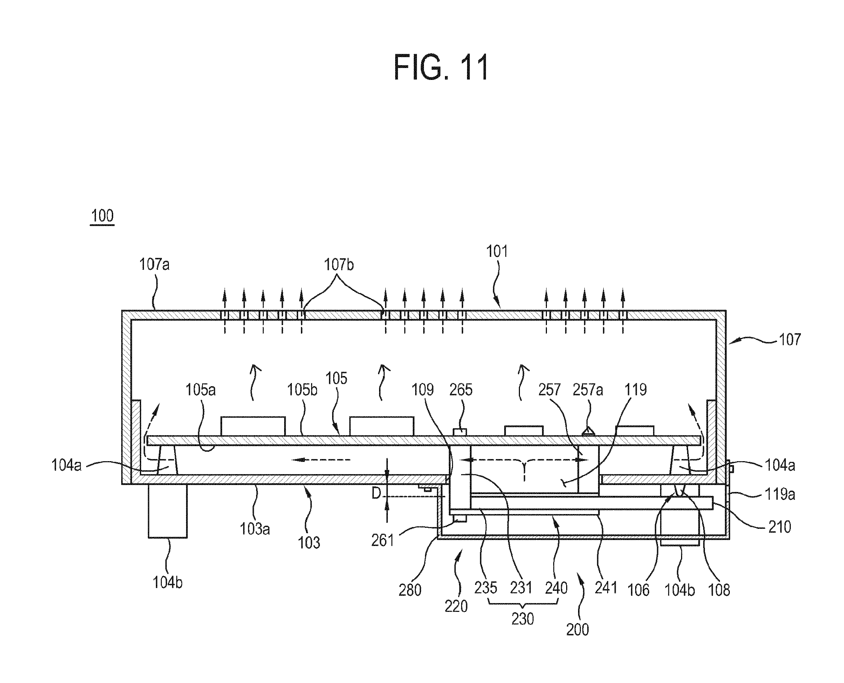

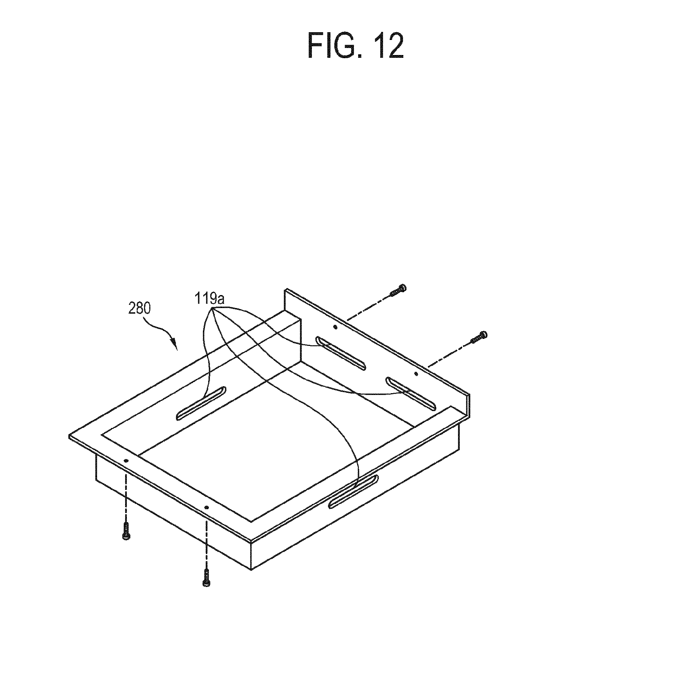

Alternatively, as shown in FIG. 11, to restrict an approach (or access) to the cable card 210 except permission of a content provider, the subscriber terminal 101 may further include a sealing cover 280 for sealing up the card portion 200. The sealing cover 280 is shaped like a box surrounding the card portion 200, and fastened to the bottom frame 103 by screws. Further, as shown in FIG. 12, the sealing cover 280 may include a plurality of air flowing openings 119a formed at positions corresponding to the air flowing space 119 so as to assist air convection in the air flowing space 119.

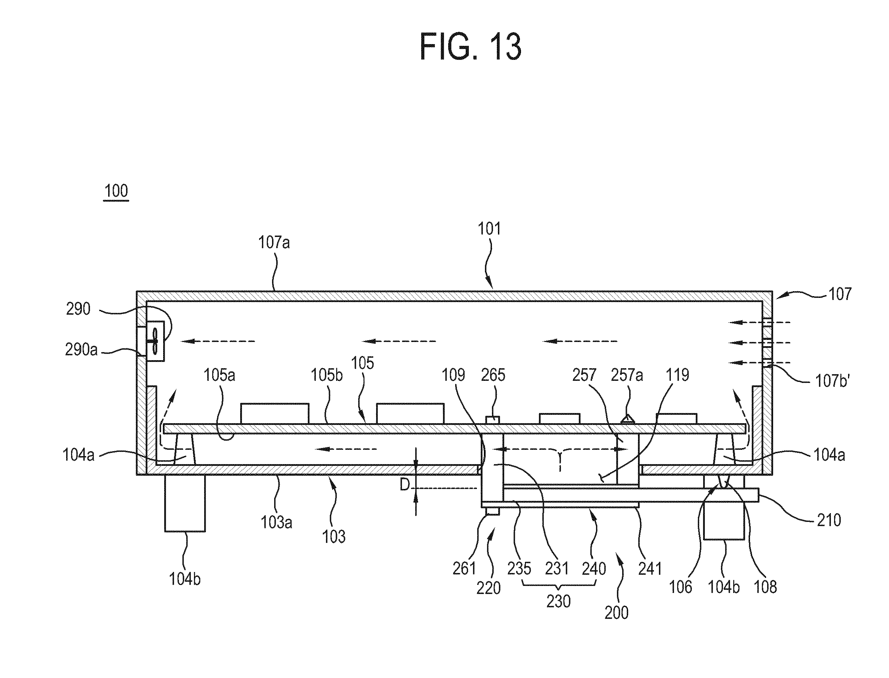

Further, as shown in FIG. 13, to promote air flow in the air flowing space 119 and easily dissipate heat radiating from the cable card 210, the subscriber terminal 101 may further include a blowing fan 290 for blowing air.

The blowing fan 290 is installed near a blowing opening 290a formed on one lateral wall of the upper cover 107, thereby discharging air in the subscriber terminal 101 to the outside or introducing external air into the subscriber terminal 101 in accordance with rotating directions. According to an exemplary embodiment, it will be assumed that the blowing fan 290 operates to discharge air in the subscriber terminal 101 to the outside.

At this time, a plurality of ventilation openings 107b' of the upper cover 107 are formed on a lateral wall opposite to the lateral wall of the upper cover 107 where the blowing fan 290 is installed.

When the blowing fan 290 operates, the external air is introduced into the subscriber terminal 101 via the ventilation openings 107b' and the air flowing space 119, so that both heat caused by circuit parts of the subscriber terminal 101 and heat caused by the cable card 210 can be radiated toward the outside of the subscriber terminal 101 through the blowing openings 290a.

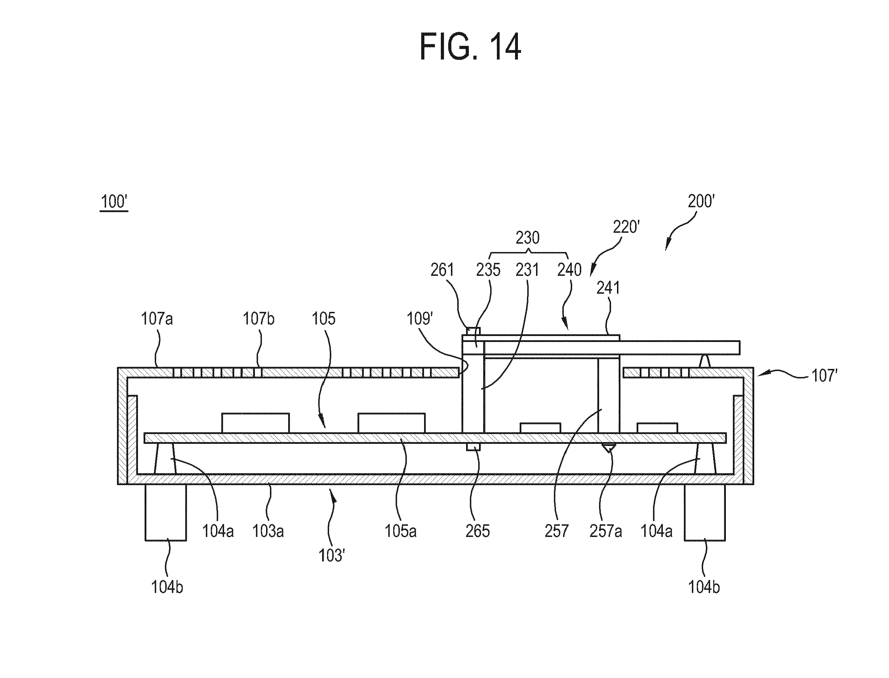

In the foregoing set-top box 100 according to an exemplary embodiment, the card portion 200 is installed on the bottom 105a of the main substrate 105, but not limited thereto. For example, in a set-top box 100' as shown in FIG. 14, a card mounting portion 220' of a card portion 220' may be installed on a top surface 105b of the main substrate 105 where circuit parts are installed. In this case, an exposure opening 109' for exposing the connection socket 230 of a card mounting portion 220' is formed on not the bottom frame 103' but a top surface 107a of an upper cover 107'. Thus, the set-top boxes 100 and 100' are improved in degrees of freedom on designing in light of installing the card portions 220 and 220'.

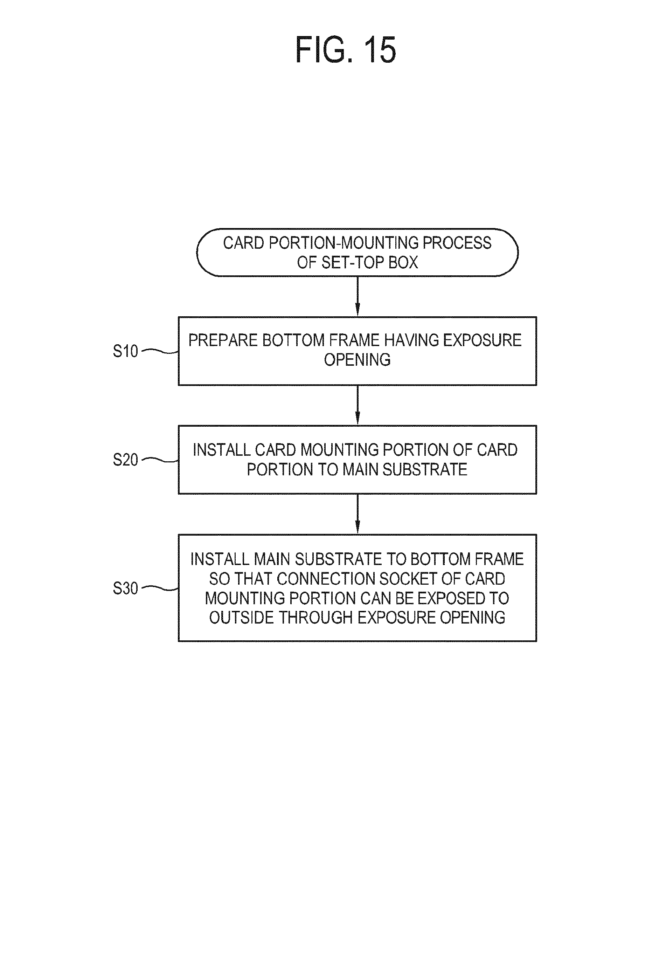

A method of mounting the card portion 200 of the foregoing set-top box 100 according to an exemplary embodiment will be described below in detail with reference to FIG. 15.

First, the bottom frame 103 formed with the exposure opening 109 on the bottom 103a thereof for exposing the connection socket 230 of the card mounting portion 220 is prepared (S10).

Then, the card portion 200 is detachably mounted to the bottom of the main substrate 105 (S20). That is, the second socket portion 235 is disposed at the mounting space in the left end portion of the guide frame 241, and the first pin terminals 236 of the top surface 235a of the second socket portion 235 are inserted in and connected to the first pin receiving holes 233 of the first socket portion 231. Further, the first pillars 252 and 253 of the first fastener 251 are fastened to the opposite end portions of the second socket portion 235 and the opposite sides of the left end portion of the guide frame 241 by the second fastening screws 261. In result, the first socket portion 231, the second socket portion 235 and the guide frame 241 are assembled into the connection socket 230. The connection socket 230 is electrically connected to the main substrate 105 as not only the right end portions of the guide frame 241 are locked to the locking grooves 105d of the main substrate 105 by the locking projections 256a and 257a of the second pillars 256 and 257 but also substrate projection terminals 117 protruding from the bottom 105a of the main substrate 105 are inserted in substrate accommodating holes 232 of the first socket portion 231. Then, the first pillars 252 and 253 of the first fastener 251 are fastened to the main substrate 105 by the third fastening screw 265, thereby mounting the connection socket 230 to the main substrate 105.

Alternatively, as shown in FIG. 10, the card portion 200 may be provided so that the connection socket 230 can be detachably mounted to the bottom frame 103 by a fastener 250". In this case, the connection between the substrate projection terminals 117 protruding from the bottom 105a of the main substrate 105 and the substrate accommodating holes 232 of the first socket portion 231 may be achieved when the main substrate 105 is installed inside the bottom frame 103.

Like this, the main substrate 105 mounted with the connection socket 230 is installed inside the bottom frame 103 and then fastened to the first to fourth fixing lugs 104 by the first fastening screws 259 so that the connection socket 230 of the card mounting portion 220 can be exposed to the outside through the exposure opening 109 of the bottom frame 103 (S30). At this time, the first socket portion 231 protrudes outward by a predetermined distance D or more from the bottom 103a of the bottom frame 103 through the exposure opening 109 of the bottom frame 103. Thus, there is provided the air flowing space 119 via which air can flow by convection from between the bottom 103a of the bottom frame 103 and an upper side of the card slot portion 240 toward the direction of both sides of the guide frame 241 and an inlet direction through the exposure opening 109 of the bottom frame 103 in the state that the cable card 210 is inserted in the card insertion slot 245 of the guide frame 241 and connected to the second socket portion 235.

Next, when the first socket portion 231, the second socket portion 235, the card slot portion 240 or the like needs to be repaired or replaced due to a connection defect or the like, the connection socket 230 can be detached as follows.

First, from the outside of the bottom 103a of the bottom frame 103, the second fastening screws 261 are removed through the exposure opening 109.

Then, the locking projections 256a and 257a of the first pillars 256 and 257 locked to the locking groove 105d of the main substrate 105 are released, thereby removing the guide frame 241. At this time, the second socket portion 235 accommodated in and supported by the guide frame 241 and the first socket portion 231 connected to the second socket portion 235 may be removed together with or separately from the guide frame 241.

Then, the first socket portion 231 and/or the second socket portion 235 causing the connection defect is repaired or replaced. Next, the first socket portion 231, the second socket portion 235, and the guide frame 241 are coupled as described above and assembled into the connection socket 230. Such an assembled connection socket 230 is coupled and mounted to the main substrate 105 like that of the mounting process.

Consequently, the first socket portion 231, the second socket portion 235, the guide frame 241 and the like are easily separated and repaired or replaced using the fastener 250 from the outside of the bottom 103a of the bottom frame 103 without opening the upper cover 107.

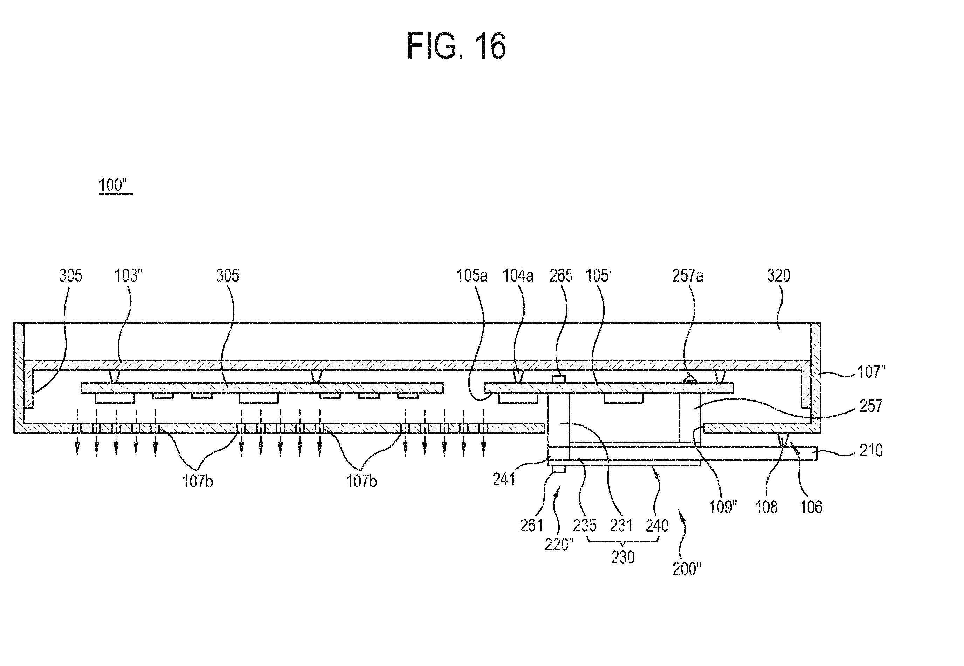

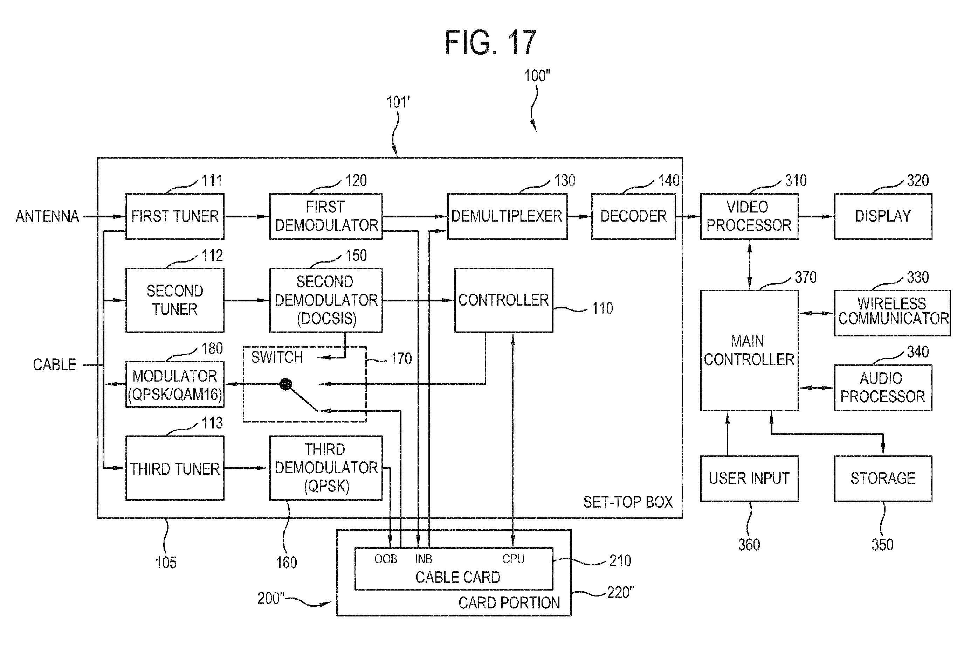

FIG. 16 and FIG. 17 are a cross-section view and a block diagram showing a display apparatus with a card portion according to another exemplary embodiment.

A display apparatus 100" according to an exemplary embodiment is a device for providing an open cable set-top box function, and may for example include a digital TV, a PC, a notebook PC, and the like device capable of displaying an image. Below, a digital TV will be described as an example of the display apparatus 100".

As shown in FIG. 16 and FIG. 17, the display apparatus 100" is a digital TV with an open cable set-top box function, and includes a set-top box 101', a video processor 310, a display 320, a wireless communicator 330, an audio processor 340, a storage 350, an user input 360, and an main controller 370.

The set-top box 101' is the same as the set-top box 100 described in FIG. 2 to FIG. 10 except that a card mounting portion 220" of a card portion 200" is installed on the top surface 105a that faces an inner surface of a rear cover 107" (see the bottom in the drawings) of the set-top box substrate 105' where circuit parts are installed and exposed to the outside through an exposure opening 109" of the rear cover 107", and the bottom frame 103" is installed on the rear (see the bottom in the drawings) of the display panel of the display 320.

Further, the rear cover 107" and the bottom frame 103" form a housing that supports the set-top box substrate105' and a display apparatus substrate 305 and surrounds the set-top box substrate 105' and the display apparatus substrate 305.

As necessary, the set-top box 101' may selectively include the sealing cover 280 and/or the blowing fan 290 described with reference to FIG. 11 to FIG. 13.

On the top surface of the display apparatus substrate 305, circuit parts that constitute a video processor 310, a wireless communicator 330, an audio processor 340, a storage 350, a user input 360, a main controller 370, etc. are installed.

The video processor 310 processes a video signal output from the decoder 140 to be displayed as an image. The video processor 310 may have image enhancing, scaling and the like function.

The display 320 displays an image based on the video signal processed by the video processor 310. The display 320 may include a liquid crystal display (LCD), a plasma display panel (PDP), an organic light emitting diode (OLED), or the like display panel (not shown) for displaying an image, and a panel driver (not shown) for fulfill timing control so that the video signal can be displayed on the display panel.

The wireless communicator 330 communicates with other devices such as a mobile device or the like. The wireless communicator 330 may be achieved by a module for short-range wireless communication, i.e. at least one of modules such as wireless fidelity (Wi-Fi), Bluetooth, infrared data association (IrDA), Zigbee, wireless local areal network (WLAN), and ultra-wideband (UWB).

The audio processor 340 processes an audio signal output from the decoder 140 and outputs it to a loudspeaker SPK.

The storage 350 stores a content (e.g., broadcast channel, video on demand (VOD), etc.) displayed on the display 320, and/or a firmware or control program for controlling the display apparatus 100". The storage 350 may be achieved by a flash memory, a hard disk, or the like nonvolatile memory.

The user input 360 receives a user's command. The user input 360 may include a remote controller (not shown), and a remote control signal receiver that receives a remote control signal including key input information corresponding to a user's input from the remote controller.

The main controller 370 generally controls the operations of the display apparatus 100". The main controller 370 may be achieved by a CPU. Further, the main controller 370 may further include a DDR or the like volatile memory for loading at least a part of stored operation system so that the CPU can have a rapid access.

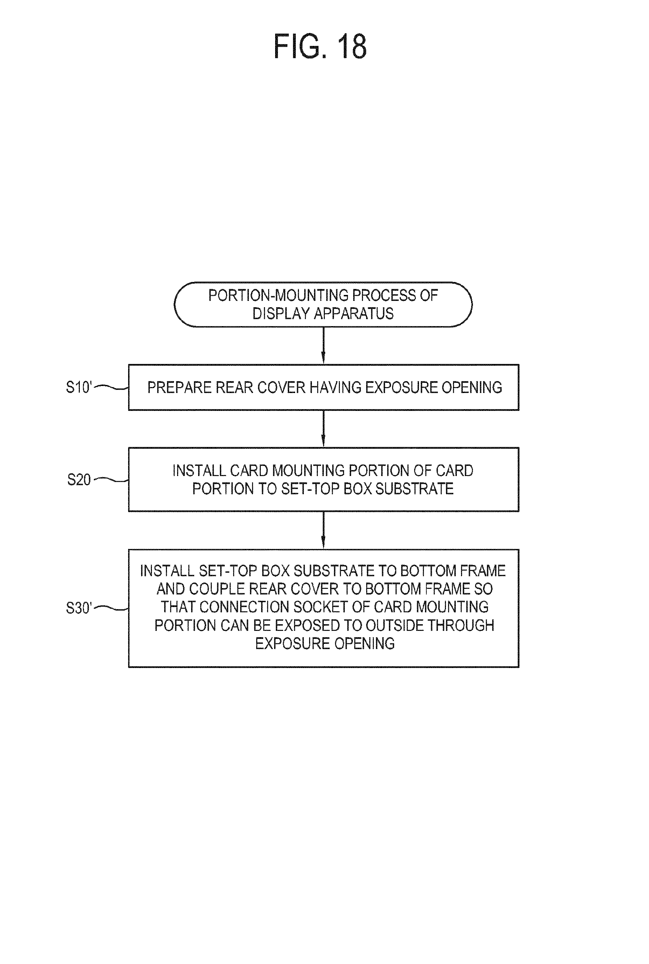

A method of mounting the card portion 200" of the foregoing display apparatus 100" according to another exemplary embodiment will be described below in detail with reference to FIG. 18.

First, the rear cover 107" with the exposure opening 109" for exposing the connection socket 230 of the card mounting portion 220" to the outside is prepared (S10').

Then, the card portion 200" is detachably mounted to the top surface 105b of the set-top box substrate 105' (S20). The operation of mounting the card portion 200" to the top surface 105b of the set-top box substrate 105' is the same as the foregoing operation of mounting the card portion 200 described with reference to FIG. 15 except that the card portion 200" is mounted to not the bottom 105a of the set-top box substrate 105' but the top surface 105b mounted with circuit parts.

Further, alternatively, in the card portion 200", the connection socket 230 may be detachably installed to the rear cover 107" by a fastener 250" as shown in FIG. 10. In this case, the connection between substrate projection terminals protruding from the top surface 105b of the set-top box substrate 105' and substrate accommodating holes of the first socket portion 231 may be fulfilled when the rear cover 107" is coupled to the bottom frame 103" in the operation S30'.

Then, the set-top box substrate 105' mounted with the connection socket 230 is installed in the bottom frame 103" and fastened to the first to fourth fixing lugs 104a by the first fastening screws, and the rear cover 107" is coupled to the bottom frame 103" so that the connection socket 230 of the card mounting portion 220" can be exposed to the outside through the exposure opening 109" (S30'). At this time, the first socket portion 231 protrudes outward by a predetermined distance D or more from a rear surface 107a of the rear cover 107" through the exposure opening 109" of the rear cover 107". Thus, there is provided the air flowing space 119" via which air can flow by convection from between the rear surface 107a of the rear cover 107" and the guide frame 241 toward the opposite directions and an inlet direction of the upper guide frame 241 through the exposure opening 109" of the rear cover 107 in the state that the cable card 210 is inserted in the card insertion slot of the guide frame 241 and connected to the second socket portion 235.

Then, the display panel of the display 320 is installed in a front space of the rear cover 107" so that the rear surface can contact the bottom frame 103".

Operations of replacing the first socket portion 231, the second socket portion 235, the card slot portion 240 or the like due to a connection defect and the like are the same as the repairing or replacing operations for the card portion 200 described with reference to FIG. 15. Thus, repetitive descriptions will be avoided.

As described above, there are provided a set-top box 100, 100' and display apparatus 100" having a discrete-type card portion 200, 200" and card portion-mounting methods thereof, in which the card portion 200, 200" is readily detached and attached from the outside since it is exposed to the outside through the exposure opening 109, 109', 109". In result, the maintenance and replacement of the card portion 200, 200" are easy.

Further, the card portion 200 of the set-top box 100 can be installed on the bottom 105a of the main substrate 105, where circuit parts are not mounted, by forming the exposure opening 109 on the bottom frame 103. In result, the usable area of the main substrate 105 increases, and thus the sizes of the main substrate 105 and set-top box 100 are decreased.

Further, the first socket portion 231 can protrude outward by a predetermined distance or more from the bottom frame 103, the upper covers 107, 107' or the rear cover 107" through the exposure opening 109, 109', 109" of the bottom frame 103, the upper covers 107, 107' or the rear cover 107". Thus, there is provided the air flowing space 119, 119" via which air can flow by convection from between the guide frame 241 and the bottom frame 103, the upper covers 107, 107' or the rear cover 107" in at least some directions, for example, the opposite directions and inlet direction of the guide frame 241 in the state that the cable card 210 is connected to the second socket portion 235 through the guide frame 241. In result, a cooling efficiency for the card portion 200, 200" is improved, and thus there is no need of adding another cooling device, thereby reducing product costs.

Although a few exemplary embodiments have been shown and described, it will be appreciated by those skilled in the art that changes may be made in these exemplary embodiments without departing from the scope of the invention as defined in the claims. Therefore, the foregoing has to be considered as illustrative only. Accordingly, all suitable modifications and equivalents may fall within the scope of the invention as defined by the claims.

## Claims

1. A set-top box comprising:
a signal receiver configured to receive a scrambled signal;
a card portion configured to comprise a card slot portion to which a cable card for descrambling the received scrambled signal is mountable;
a substrate configured to comprise the signal receiver and electrically connectable with the card portion; and
a housing configured to support and surround the substrate,
wherein the housing comprises a first opening formed on a surface parallel with the substrate, and the card slot portion of the card portion is disposed to face the substrate to support the cable card parallel to the first opening with the first opening of the housing being between the card slot portion and the substrate.

2. The set-top box according to claim 1, wherein the card portion is installed on a first surface of the substrate.

3. The set-top box according to claim 1, wherein the card portion is installed on a second surface of the substrate.

4. The set-top box according to claim 1, 2 or 3, wherein the card portion comprises a connection socket mountable with the cable card and electrically connectable with the substrate,
the connection socket comprising:
a first socket portion configured to protrude through the first opening to electrically connect with the substrate;
a second socket portion configured to comprise a first surface electrically connectable with the first socket portion and a second surface electrically connectable with the cable card; and
the card slot portion configured to support the second socket portion and guide movement of the cable card parallel with the first opening so that the cable card is mounted to the card slot portion by being connected with the second surface of the second socket portion.

5. The set-top box according to claim 4, wherein the first opening has a size corresponding to at least a part of the card slot portion.

6. The set-top box according to claim 4 or 5, wherein the first socket portion protrudes outward from the housing by at least a distance from the housing through the first opening of the housing.

7. The set-top box according to claim 4, 5 or 6, further comprising an air flowing space through which air is flow-able by convection from between the housing and the card slot portion in at least one direction through the first opening in the state that the cable card is mounted on the card slot portion by being connected to the second socket portion.

8. The set-top box according to any one of claims 4 to 7, wherein the connection socket further comprises a fastener configured to detachably fasten the card slot portion to the substrate and/or the housing.

9. The set-top box according to any one of the preceding claims, wherein the housing further comprises a plurality of second openings for air flow in the set-top box outward.

10. The set-top box according to claim 9, further comprising a blowing fan to blow air for the air flow in the set-top box.

11. The set-top box according to any one of claims 4 to 10, wherein the housing comprises a ground disposed to contact and ground the cable card in the state the cable card is mounted to the card slot portion by being connected with the second surface of the connection socket.

12. The set-top box according to claim 11, wherein the ground comprises a contact projection formed on a surface of the housing facing the cable card mounted to the card slot portion.

13. The set-top box according to any one of claims 7 to 12, further comprising a sealing cover configured to seal up the connection socket.

14. The set-top box according to claim 13, wherein the sealing cover comprises a plurality of third openings formed at a position corresponding to the air flowing space where air flow by convection through the first opening.

15. A display apparatus comprising:
a signal receiver configured to receive a scrambled signal;
a card portion configured to comprise a card slot portion to which a cable card for descrambling the scrambled signal is mountable;
a video processor configured to process the descrambled signal to be displayed as an image;
a display configured to display a signal processed by the video processor;
a substrate configured to comprise the signal receiver and electrically connectable with the card portion; and
a housing configured to support and surround the substrate,
wherein the housing comprises a first opening formed on a surface parallel with the substrate, and the card slot portion of the card portion is disposed to face the substrate to support the cable card parallel to the first opening with the first opening of the housing being between the card slot portion and the substrate.
